## Europäisches Patentamt

## European Patent Office

## Office européen des brevets

(11) Veröffentlichungsnummer: **0 048 872**
**B1**

(12) **EUROPÄISCHE PATENTSCHRIFT**

(45) Veröffentlichungstag der Patentschrift: 07.08.85

(51) Int. Cl.⁴: **C 30 B 19/06**

(21) Anmeldenummer: **81107190.1**

(22) Anmeldetag: **11.09.81**

(54) **Vorrichtung zur Durchführung einer Flüssigphasen-Epitaxie.**

(30) Priorität: **29.09.80 DE 3036643**

(43) Veröffentlichungstag der Anmeldung:
**07.04.82 Patentblatt 82/14**

(45) Bekanntmachung des Hinweises auf die
Patenterteilung:
**07.08.85 Patentblatt 85/32**

(84) Benannte Vertragsstaaten:
**FR GB IT**

(56) Entgegenhaltungen:
**FR-A-2 439 477**
**US-A-3 759 759**
**US-E- 28 140**

**INSTRUMENTS AND EXPERIMENTAL
TECHNIQUES, vol. 19, no. 4, pt. 2, 1976, S.G.
ZHILENIS et al. "Cassette for batch growth of
layers by the liquid-epitaxy method", Seiten
1221-1222**

(73) Patentinhaber: **Siemens Aktiengesellschaft
Berlin und München Wittelsbacherplatz 2
D-8000 München 2 (DE)**

(72) Erfinder: **Heinen, Jochen Dr.
Dianastrasse 38
D-8013 Haar (DE)**

(56) Entgegenhaltungen:
**IEEE TRANSACTIONS ON ELECTRON
DEVICES, vol. ED-24, no. 7, 1977, T. NIINA et al.
"An improved liquid phase epitaxial growth
method for mass production of GaP green
LED's", Seiten 946-950**

## Beschreibung

Die vorliegende Erfindung bezieht sich auf eine Vorrichtung, wie sie im Oberbegriff des Patentanspruchs 1 angegeben ist.

Aus Journ. of Appl. Physics, Bd, 48 (1977), Seiten 2485—92 ist eine Vorrichtung für Flüssigphasen-Epitaxie zur Herstellung von Halbleiterschichten auf gleichzeitig mehreren Substratscheiben bekannt. Es handelt sich dabei um eine Vorrichtung, in der ein Schmelztiegel vorhanden ist. Von der Seite sind durch diesen Schmelztiegel Platten als verschiebbare Zungen eingefügt, die jeweils eine Bohrung aufweisen. Befindet sich diese Bohrung in dem Schmelztiegel, füllt sie sich mit einer dem Volumen der Bohrung entsprechenden, als Aliquot bezeichneten Menge der Schmelze. Die Zunge wird dann derart verschoben, daß diese Bohrung aud dem Schmelztiegel herausgeschoben wird und über eine bereitgehaltene Substratscheibe gelangt. Aus der in der Bohrung enthaltenen, nunmehr über der Substratscheibe befindlichen Schmelze wird nach dem Prinzip der Flüssigphasen-Epitaxie eine Halbleiterschicht auf der Oberfläche der Substratscheibe abgeschieden. Durch eine Anordnung einer Vielzahl solcher mit Bohrungen versehener Platten oder Zungen in dem Schmelztiegel und durch Anordnung einer entsprechenden Vielzahl von Substratscheiben lassen sich durch gleichzeitiges Verschieben, Anlösen und nachfolgende Abscheidung aus der Schmelze auf einer entsprechenden Vielzahl Substratscheiben jeweils eine Schicht abscheiden. Eine Verschiebung der Substratscheiben ist hier nicht vorgesehen.

Es ist aus der DE—OS 27 30 358 bekannt, in einer sukzessiven Folge nacheinander eine Vielzahl von Substratscheiben mit mehreren Epitaxie-Schichten aufeinander zu versehen. Diese Vorrichtung besteht aus einer Vielzahl von Schmelztiegeln und einer verschiebbaren Zunge mit einer der Anzahl der Substratscheiben entsprechenden Vielzahl von Ausnehmungen für die Aufnahme der Substratscheiben. Wenn dort auch gleichzeitig mehrere Schichten auf verschiedenen Substratscheiben abgescheiden werden, so erfolgt die Abscheidung der n-ten Schicht auf der m-ten Substratscheibe zu einem anderen Zeitpunkt und damit zu anderen Temperaturbedingungen als die n-te Schicht auf der (m+m')-ten Substratscheibe.

Aus der DD—PS 115 580 ist eine Vorrichtung für Flüssigphasen-Epitaxie bekannt, in der in waagerechter Lage jeweils zwei unmittelbar Rücken an Rücken liegende Scheiben der Schmelze ausgesetzt werden. Die Scheiben werden in die Vorrichtung eingelegt. Es ist ein auf dem Grundkörper aufsetzbarer Schieber vorgesehen, der einen Anteil des aus der Schmelze durch einen Schlitz des Grundkörpers herausragenden Anteils der jeweiligen Scheiben erfaßt, nämlich um die in dem Schlitz gleitenden, aufeinanderliegenden Scheiben von einer Schmelze zur anderen Schmelze zu verschieben.

Aus der DE—OS 23 37 238 ist eine Vorrichtung mit dem Merkmalen des Oberbegriffes des Patentanspruchs 1 bekannt. Es ist dort in einer ersten Ausnehmung der einen zu verschiebenden Zunge ein Sättigungskristall bzw. Vorsubstrat und erst in einer weiteren Ausnehmung das eigentliche, mit zwei Schichten zu beschichtende Substrat enthalten, das hier eine einzige, waagerecht unter der jeweiligen Schmelze liegende Scheibe ist. Sollte vorgesehen sein, daß mit dieser Vorrichtung auf zwei in der Zunge hintereinanderliegende Scheiben jeweils zwei oder gar noch mehr Schichten aufeinander abzuscheiden sind, würde dort die Abscheidung der ersten Schicht auf der zweiten Scheibe bei anderer Temperatur erfolgen als die Abscheidung der ersten Schicht auf der ersten Scheibe. Entsprechend würde auch die zweite Schicht der zweiten Scheibe unter anderen Bedingungen abgeschieden werden als die zweite Schicht der ersten Scheibe.

Es ist eine Aufgabe der vorliegenden Erfindung, eine neue Vorrichtung zur Durchführung einer Flüssigphasen-Epitaxie anzugeben, bei der auf einer Vielzahl von Substratscheiben mehrere Epitaxie-Schichten übereinander abgeschieden werden können, wobei auf allen Substratscheiben dieser Vielzahl von Substratscheiben die jeweilige Schicht gleichzeitig, d.h. zu gleichen Bedingungen, abgeschieden wird.

Diese Aufgabe wird mit einer Vorrichtung nach dem Oberbegriff des Patentanspruchs 1 gelöst, die erfindungsgemäß die Merkmale des Kennzeichens des Anspruchs 1 aufweist. Weitere Ausgestaltungen und Weiterbildung der Erfindung gehen aus den Unteransprüchen hervor.

Für eine Anzahl Halbleiter-Bauelemente, wie z.B. Lumineszenzdioden, Injektions-Laser, IMPATT-Dioden und Solar-Konzentratorzellen, werden mehrschichtige Krillstallstrukturen benötigt. Die einzelnen Shichten unterscheiden sich in ihrer Zusammensetzung voneinander. Aus Gründen der Reproduzierbarkeit müssen aber die physikalischen Eigenschaften dieser einzelnen Schitch in der ganzen Serie der hergestellten Bauelemente übereinstimmten. Dies stellt hohe Anforderungen an ein rationelles Massenherstellungsverfahren, bei dem Zug um Zug eine Schicht nach der andern auf gleichzeitig einer Vielzahl von Substratscheiben hergestellt wird. Es ist also defär Sorge zu tragen, daß die für die einzelne Schicht der vielen gleichzeitig zu beschichtenden Substratscheiben vorgesehene Schmelz genügend homogen ist und daß kein Materialtransport von einer Schmelze zur anderen für die weitere Schicht vorgesehenen Schmelze erfolgt. Mit der erfindungsgemäßen Vorrichtung ist gewährleistet, daß jeweils eine Schicht aller Substratscheiben bei identischer Temperaturabsenkung abgeschieden wird, worin ein Unterschied zu der Vorrichtung nach der obengebannten DE—Offenlegungsschrift 27 30 358 vorliegt.

Weitere Erläuterungen der Erfindung werden nachfolgend anhand der Beschreibung von Figuren zu Ausführungsbeispielen der Erfindung gegeben, wobei spezielle Einzelheiten der beschriebenen Ausführungsformen als beispielhaft zu betrachten sind und keine Beschränkung für gleichwirkende, äquivalente Konstruktionsvarianten für diese Einzelheiten darstellen.

Fig. 1—3 zeigen eine Gesamtansicht.

Fig. 4 zeigt eine perspektivische Teilansicht.

Fig. 5 zeigt eine einzelnes Konstruktionsteil.

Figs. 6 a—c zeigen Stufen der Betriebsweise.

Mit 2 is das Teil mit den Abscheidekammern 3 bezeichnet. Mit 4 ist das Teil mit den Schmelztiegeln 5 bezeichnet. Die Teile 2 und 4 liegen gegeneinander gleitend verschiebbar aufeinander. Die Auflagefläche zwischen diesen beiden Teilen 2 und 4 ist mit 6 bezeichnet. Ein auf dem Teil 4 aufliegender, die Schmelzkammern 5 verschießender Deckel ist mit 7 bezeichnet.

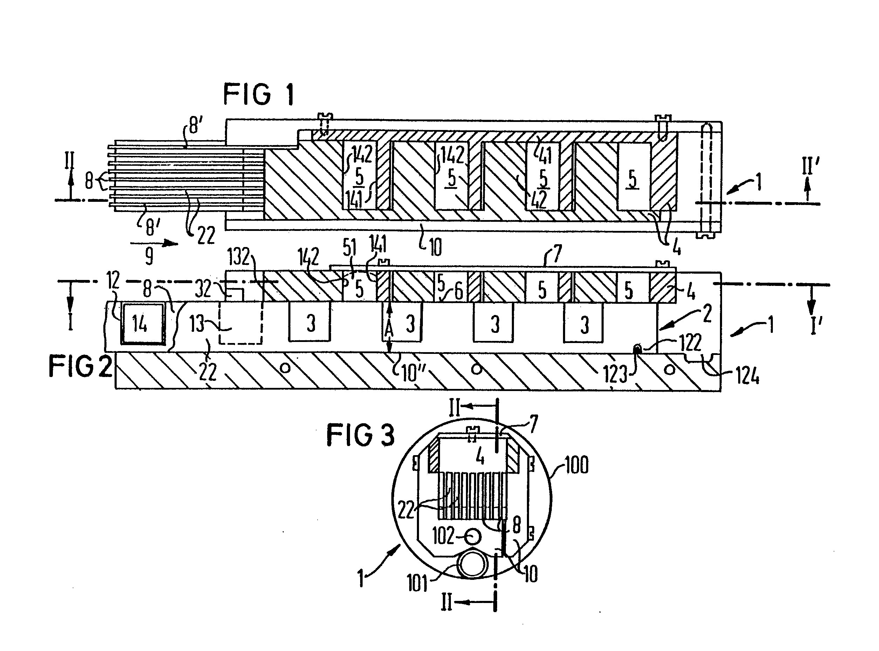

Die Schieberzeugen 8 befinden sick teilweise in den Schlitzen des Teils 2 mit den Abscheidekammern 3. Die Schieberzungen 8 ragen in den Fig. 1 und 2 linksseitig wenigstens so weit heraus, wie dies für das im Betrieb erfolgende Verschieben der Schieberzungen 8 in Pfeilrichtung 9 erforderlich ist. Mit 10 ist das zusammenfassende Gehäuse bezeichnet, mit dem das Teil 2 mit den Abscheidekammern 3, die Schieberzungen 8 und das Teil 4 mit den Schmelzkammern 5 zusammengehalten werden. Wie aus der Fig. 3 ersichtlich, kann diese Gehäuse aus zwei miteinander verschraubten Teilen bestehen, wobei das Teil 4 (mit den Schmelzkammern 5) und der Deckel 7 weitere Teile dieses Gehäuses sind. Das Gehäuse 10 ist als feststehend anzusprechen, in dem das Teil 2 und die Schieberzungen 8 (beide für sich getrennt) verschiebbar sind.

Die Fig. 1 zeigt die Ansicht der erfindungsgemäßen Vorrichtung 1 in dem Betriebszustand, der vor dem Umfüllen der Schmelze aus dem Schmelztiegel 5 in die Abscheidekammern 3 vorliegt. Für dieses Umfüllen wird das Teil 2 derart in Richtung des Pfeiles 9 verschoben, daß die Abscheidekammern 3 unter die Schmelztiegel 5 gelangen. Beim Beispiel der Fig. 1 bis 3 ist das Teil 2 gegenüber dem mit dem Gehäuse 10 fest verbundenen Teil 4 verschiebbar. Prinzipiell könnte auch das Teil 4 verschiebbar und das Teil 2 feststehend sein. Die Abstände der Abscheidekammern 3 voneinander und die Abstände der Schmelztiegel 5 voneinander sind gleich groß zu wählen und so groß vorzugeben, daß in der in Fig. 1 dargestellten Ausgangsstellung die Schmelztiegel 5 und die Abscheidekammern 3 gegeneinander verschlossen sind und im verschobenen Zustand genügend weit überlappen.

Die Schieberzungen 8 haben Ausnehmungen 12 für die Aufnahme je einer Substratscheibe. Für den Fall, daß mit Vorsubstrat gearbeitet werden soll, ist noch je eine weitere Aufnahme 13 (gestrichelt dargestellt) in einer jeden Schieberzunge 8 vorgesehen. In der Aufnahme 12 befinden sich die zu beschichtenden Substratscheibe 14. Die gleich große Vorsubstratscheibe, die in die Aufnahme 13 einzusetzen ist, ist hier der Übersichtlichkeit halber nicht dargestellt.

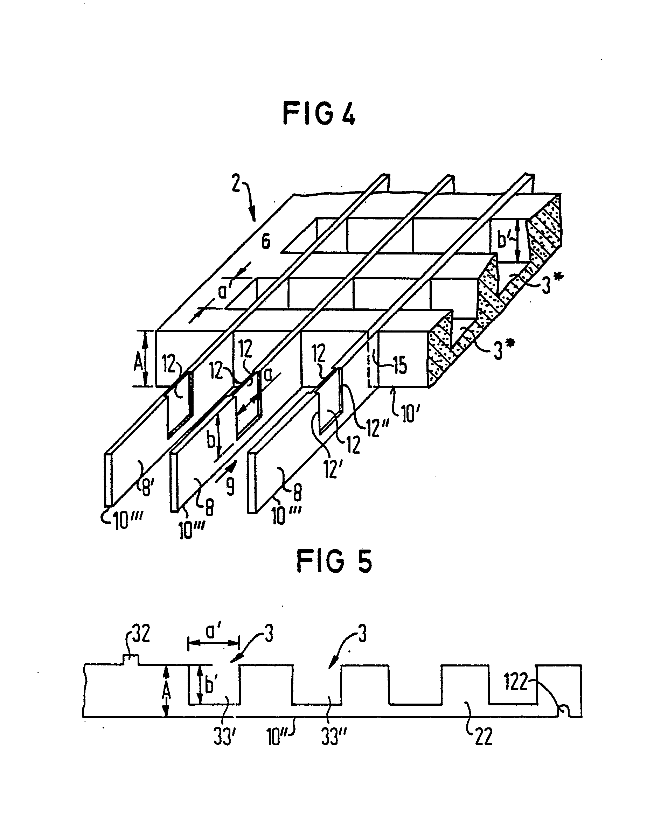

Zum besseren Verständnis der erfindungsgemäßen Vorrichtung zeigt Fig. 4 eine Detaildarstellung des Teils 2 mit den Abscheidekammern 3 und drei Schieberzungen 8, 8' bei denen nur dei Ausnehmungen 12 für die zu beschichtende Substratscheibe gezeigt sind. Wie aus der Darstellung ersichtlich, sind diese Ausnehmungen 12 einander gegenüberliegend beidseitig in den Schieberzungen 8 vorgesehen, so daß mit zwei Schieberzungen 8, bereits vier Substratscheiben in den vier Ausnehmungen 12 Aufnahme finden können. Die Schieberzungen 8 stehen senkrecht zu der Auflagefläche 6, so daß die in die Ausnehmungen 12 eingesetzten Substratscheiben bei Verscheibung in Pfeilrichtung 9 in senkrechter Stellung durch die Abscheidekammern 3 hindurchgeführt werden. Aus der Darstellung in Fig. 4 ist auch zu erkennen, wie bei gemeinsamer Verschiebung 9 der Schieberzungen 8, 8' diese in den Ausnehmungen 12 befindlichen Substratscheiben von einer Abscheidekammer 3 in die nächstfolgende Abscheidekammer 3 gelagen. Dus Ausnehmungen 12 und die Substratscheiben sind zueinander so bemessen, daß die Substratscheiben (wie hier nicht dargestellt) die jeweilige Ausnehmung 12 voll ausfüllen, d.h. kein wesentlicher, unnötiger unde störender Zwischenraum zwischen den Rändern der Substratscheibe und den Rändern der Ausnehmung auftritt, und die freie Oberfläche der Substratscheibe mit der Seitenoberfläche der jeweiligen Schieberzunge 8 möglichst exakt eine Ebene bildet. Auf diese Weise ist gewährleistet, daß die Schieberzungen 8 gleitend derart durch die Schlitze 15 hindurchgeschoben werden können, daß selbst bei Hindurchschieben der beiderseitigen Ausnehmungen mit darin befindlichen Substratscheiben ausreichende Abdichtung der Abscheidekammer 3 gegenüber dem Außenraum und gegenüber benachbarten Abscheidekammern 3 vorliegt, und außerdem auch in Zwischenräumen zwischen Substratscheibe und Aufnahme 12 überhaupt kein Materialanteil von einer Abscheidekammer 3 in die nächste Abscheidekammer 3 mit transportiert wird. In der perspektivischen Darstellung der Fig. 4 ist mit gestrichelter Linie ergänzend ein solcher Schlitz 15 angedeutet.

Damit die in den Ausnehmungen 12 senkrecht stehenden Substratscheiben aus diesen Ausnehmungen beim Durchschub 9 der Schieberzungen 8 durch das Teil 2 in den Abscheidekammern 3 nicht herausfallen, sind die Abmessungen a und b der Ausnehmungen 12 (und der Substratscheiben) um so viel größer als die korrespondierenden Abmessungen a' und b' der Abscheidekammern 3 bemessen, daß die Unterkante der in die Ausnehmung 12 eingelegten Substratscheibe ständig bis unter den Boden 3* der Abscheidekammer 3 reicht und beim Durchschieben in Richtung 9 entweder die Vorderkante 12' oder die Hinterkante 12'' noch oder bereits wieder im massiven Anteil des Teils 2, d.h. außerhalb der Abscheidekammer 3, sich befindet. Die in der jeweiligen Aufnahme 12 befindliche Substratscheibe wird dadurch ständig sicher in der Aufnahme 12 gehalten.

Die Anordnung von Substratscheiben auf beiden Seiten einer Schieberzunge 8 ermöglicht, vergleichsweise zum Stand der Technik doppelt soviele Subtratscheiben je Schieberzunge 8 gleichzeitig zu bearbeiten. Zu diesem wirtschaltlichen Vorteil kommt aber vor allem noch ein technologischer Vorteil dieser doppelten Anordnung von Substratscheiben hinzu. Wenn die beiden in der Fig. 4 dargestellten Schieberzungen 0 so weit in Richtung 9 verschoben sind, daß sich deren Ausnehmungen 12 bereits in der Abscheidekammer 3 befinden, erfolgt von dem Anteil der Schmelze aus, die sich im Anteil der Abscheidekammer 3 zwischen den Schieberzungen 8 befindet, eine epitaktische Abscheidung nach beiden Seiten, wo sich in den Ausnehmungen 12 Substratscheiben befinden. Abweichend von der schematischen Darstellung der Fig. 4, wie insbesondere aus der Fig. 1 besser ersichtlich, sind die Abstände zwischen benachbarten Schieberzungen sehr klein gegenüber den Abmessungen a' und b', so daß die Gesamtoberfläche dieses mit Schmelze gefüllten Volumenanteils der Abscheidekammer 3 zwischen den benachbarten Schieberzungen im wesentlichen von Oberfläche der (bezüglich diese Volumenanteils einander gegenüberstehenden) beiden Substratscheiben in den Ausnehmungen 12 der beiden Schieberzungen eingenommen wird. Dies trägt ganz wesentlich zu einer Homogenität der Abscheidung auf den Substratscheiben, und zwar insbesondere ohne wesentliche (verstärkte) Randaufwachsung, wie sie von der Schiebeepitaxie her seit vielen Jahren bekannt und gefürchtet ist, bei. Bei einer wie in Fig. 1 dargestellten Vielzahl von Schieberzungen ist dieser wesentliche Vorteil für die Substratscheiben aller Schieberzungen zu erreichen, wenn man in den jeweils beiden äußeren Schieberzungen 8' auf deren jeweiliger Außenseite Ausnehmumgen (und Substratscheiben) wegläßt. Es erfolgt dann keine Abscheidung aus den jeweils beiden Volumenanteilen einer jeder Abscheidekammer 3, die sich zwischen der jeweils äußeren Schieberzunge 8' und den jeweiligen, zu den Schieberzungen 8' parallelen Außenwänden der Abscheidekammer 3 befinden.

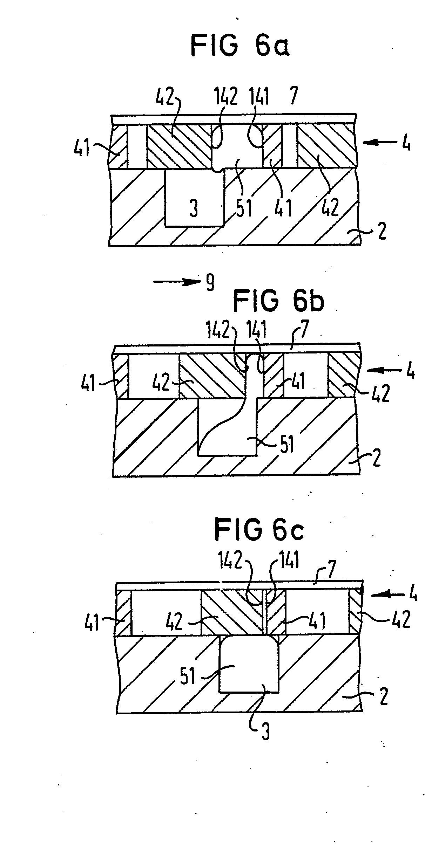

Ein besonders einfacher und damit wirtschaltlich herzustellender Aufbau einer erfindungsgemäßen Vorrichtung 1 liegt dann vor, wenn (wie in den Fig. 1 bis 3 und insbesondere in Fig. 3 andeutungsweise zu erkennen) das Teil 2 mit den Abscheidekammern 3 aus einer Anzahl einzelner Platten besteht, die in abwechselnder Folge mit den Schieberzungen 8, 8' (siehe Fig. 3) zusammengefügt sind. Fig. 5 zeigt, mit 22 bezeichnet, eine solche Platte, wie sie zwischen den Schieberzungen 8 angeordnet ist. Mit dem Bezugszeichen 3 ist auf die vier Abscheidekammern hingewiesen. Durch die Gesamtheit der Ausnehmungen 33' der einzelnen Platten 22 wied die erste Abscheidekammer 3 gebildet. Die Ausnehmungen 33'' der Platten 22 bilden die nächste Abscheidekammer 3. Alle Platten 22 des Teiles 2 sind vorteilhafterweise identisch geformte Teile, da die beiden aus Fig. 3 ersichtlichen Teile des Gehäuses 10 die voranstehend erwähnte, den Schieberzungen 8 parallele Außenwand der Abscheidekammer 3 bilden können. Die Fläche 10' des Gehäuses 10 wird zusammengenommen von den Unterkantenflächen 10'' der Platten 22 und den Unterkantenflächen 10''' der Schieberzungen 8 (siehe Fig. 4) gebildet, so daß die in der Fig. 5 eingetragene Abmessung A mit der in Fig. 4 eingetragenen Abmessung A übereinstimmt.

Die einzelnen Platten haben wie dargestellt je eine Ausnehmung 122 für die Aufnahme eines Arretierungsstiftes 123. Zusätzlich haben auch die Schieberzungen eine solche Ausnehmung. Der in Fig. 2 gezeigte Stift 123 arretiert nicht nur die Platten 22 gegeneinander, sondern auch die Schieberzungen 8, 8' mit den Platten 22, d.h. mit dem Teil 2.

Die Fig. 1 und 2 lassen den Betriebszustand der erfindungsgemäßen Vorrichtung erkennen, wie er vor dem Einfüllen der Schmelze aus den Schmelztiegeln 5 in die Abscheidekammern 3 vorliegt. Spätestens zu diesem Zeitpunkt, d.h. bevor man die Abscheidekammern 3 mit den Schmelztiegeln 5 in Verbindung bringt (durch Verschieben des Teils 2 in Richtung des Pfeils 9), befinden sich die Schieberzungen 8, 8' bereits in dem Teil 2 und teilen damit, wie aus Fig. 4 ersichtlich, die einzelnen Abscheidekammern 3 in die Teilvolumina zwischen den Schieberzungen 8, 8'. Diese Teilvolumina werden auch als Aliquots bezeichnet, denn bei in die Schmelzkammern eingefüllter Schmelze sind diese Teilvolumina diejenigen einzelnen Portionen der Schmelze, aus denen dann später die einzelne Epitaxieschicht auf der jeweiligen Substratscheibe abgeschieden wird. Bei der dargestellten Ausführungsform werden aus je einen Aliquot jedoch zwei in den Ausnehmungen 12 befindliche Substratscheiben beschichtet. Bei der wie voranstehend beschriebenen speziellen Ausführungsform des Teiles 2 aus Platten 22, die zusammen mit den Schieberzungen 8, 8' zu einem Paket vereinigt sind, sind die Schmelzkammern 3 bereits von vornherein in die erwähnten Teilvolumina aufgeteilt.

In Fig. 2 ist der Übersichtlichkeit halber nur für die von links erste Schmelzkammer 5 eine bereits eingefüllte Schmelze 51 angedeutet, und zwar durch den gestrichelt dargestellten Miniskus. Bei Verschiebung des Teiles 2 in Richtung der Pfeiles 9 kommt die Nase 32 des Teiles 2 (siehe Fig. 2 und 5) zur Anlage an der feststehenden Fläche 132 des Teiles 4 mit den Schmelztiegeln. Zu diesem Zeitpunkt stehen Abscheidekammern 3 und Schmelztiegel 5 schon so weit übereinander, wie dies die Fig. 6a andeutet. Wie ersichtlich, kann in diesem Zustand Schmelze 51 in die einzelnen Teilvolumina der Abscheidekammer 3 gelangen. Da die Schmelze 51 sehr zähflüssig ist, genügt im allgemeinen die Schwerkraft nicht, zu erreichen, daß die Schmelze 51 die Teilvolumina der

Abscheidekammer 3 zuverlässig und gleichmäßig füllt. Es ist die Anwendung eines Druckes erforderlich. Dieses unter Druck erfolgende Herauspressen der einzelnen in den Schmelztiegeln 5 befindlichen Schmelzen in die jeweilige zugehörige Abscheidekammer 3 erfolgt bei der dargestellten speziellen Ausführungsform der Erfindung—und zwar gleichzeitig für alle vier dargestellte Schmelztiegel—dadurch, daß man die anfänglich vorhandenen, aus den Fig. 1 und 2 ersichtlichen Volumina der vier Schmelztiegel 5 sukzessive verkleinert. Hierzu ist das Teil 4 mit den Schmelztiegeln 5 zweitilig ausgebildet und besteht aus den beiden kammförmig ineinandergreifenden Teilen 41 und 42. Auf jeweils einer Seite zwischen den ineinandergreifenden Kammzinken der Teile 41 und 42 liegen die Schmelztiegel 5 vor. Durch Verschieben der Teile 41 und 42 gegeneinander können diese, wie aus den Fig. 1 und 2 ersichtlich, Volumina der Schmelztiegel 5 verringert werden. Bei der dargestellten Ausführungsform der Erfindung erfolgt dieses Verschieben der Teile 41 und 42 des Teils 4 gegeneinander dadurch, daß nur das Teil 41 in der Halterung 10 fest montiert ist und das Teil 42 dagegen (ebenso wie das Teil 2) gegenüber dem Gehäuse 10 verschiebbar ist. Diese Verschiebung wird bei dieser Ausführungsform in einfacher Weise dadurch erreicht, indem die bereits oben erwähnte Anlagefläche 132 sich am Teil 42 befindet. Bei nach Anlage der Nase 32 an der Fläche 132 weiterer Verschiebung der Schieberzungen 8, 8' und damit infolge des Arretierungsstiftes 123 ebenso erfolgender Verschiebung der Teils 2, wird das Teil 42 mitgenommen und gegen das feststehende Teil 41 verschoben. Das Ergebnis dieser Verschiebung des Teils 42 ist—wie aus Fig. 6b gut ersirchtlich—daß sich die jeweilige an dem Teil 42 befindliche Innenwandfläche 142 des jeweiligen Schmelztigels 5 auf die ihr jeweils gegenüberliegende Innenwandfläche 141 des Teils 41 zubewegt. Dabei auftretende Verringerung der einzelnen Abstände der Flächen 142 und 141 voneinander in den einzelnen Schmelztiegeln 5 führt dazu, daß die bereits oben erwähnte Verringerung der Schmelztiegel-Volumina erfolgt, womit die Schmelze dabei aus den einzelnen, sich nun verkleinernden Schmelztigeln 5 in die einzelnen Abscheidekammern 3 herauzgepreßt wird.

Die Fig. 6b zeigt ein bereits relativ weit fortgeschrittenes Stadium in dem bereits fast die gesamte Schmelze 51 in die zwischen den Schieberzungen 8, 8' befindlichen Teilvolumina der Abscheidekammer 3 hereingepreßt ist.

Es sind Vorkehrungen getroffen, z.B. schmale Kanäle vorgesehen, durch die hindurch in den Abscheidekammern 3 enthaltenes Gas beim Einpressen der jeweiligen Schmelze entweichen kann.

Fig. 6c zeigt schließlich den Endzustand, in dem das jeweilige Volumen der einzelnen Schmelzkammern zu Null geworden ist, d.h. die jeweiligen Flächen 142 und 141 bereits aneinanderliegen. Die gesamte Schmelze des jeweiligen Schmelztiegels 5 befindet sich nun in der jeweils zugehörigen Anscheidekammer 3.

Da die Schmelze 51, solange sie sich im Schmelztigel 5 befand, bereits eine vollständige Homogenisierung erfahren hatte, sind auch die in den einzelnen Teilvolumina zwischen den Schieberzungen 8, 8' befindlichen Aliquots der Schmelze entsprechend homogen zueinander. Die später durchzuführende Abscheidung auf den Substratscheiben geht dann also von zueinander identischen Aliquots aus.

Wenn der Verschiebungszustand entsprechend der Fig. 6c erreicht ist, d.h. die einzelnen Abscheidekammern 3 mit den jeweiligen Schmelzen gefüllt sind, fällt der Arretierungsstift 123 aus den Ausnehmungen 122 heraus und gelangt in die dann unterhalb den Ausnehmungen 122 befindliche Ausnehmung 124 des Gehäuses 10. Bei herausgefallenem Arretierungsstift 123 sind die Schieberzungen 8, 8' gegenüber dem Teil 2 bzw. gegenüber den Platten 22 des Teils 2 weiter verschiebbar. Diese weiter Verschiebung der Schieberzungen 8, 8' in Richtung des Pfeils 9 läßt die in allen Ausnehmungen 12 aller Schieberzungen 8, 8' befindlichen Substratscheiben in die (von links) erste Abscheidekammer 3 gelangen.

Sofern auch noch jeweils eine Ausnehmung 13 für ein Vorsubstrat vorhanden ist, gelangt zunächst einmal dieses Vorsubstrat 13 in die erste Abscheidekammer 3. Dieses Vorsubstrat dient dann dazu, eine in den Aliquots eventuell vorhandene Übersättigung durch Abscheidung auf diesen Vorsubstratscheiben zu beseitigen. Die eigentliche vorgesehene Abscheidung erfolgt dann, nachdem—wie oben bereits beschriebendie Substratschieben der Ausnehmungen 12 in die Abscheidekammern 3 hereingeschoben sind.

Die Substratscheiben der Ausnehmungen 12 der Schieberzungen 8, 8' werden sukzessive von einer Abscheidekammer in die in Pfeilrichtung 9 nächstfolgende Abscheidekammer hereingeschoben und mit der dann jeweils weiteren Epitaxieschicht beschichtet. Nach Hindurchlaufen der Substratscheiben der Ausnehmungen 12 durch alle vier Abscheidekammern 3 hindurch besitzen diese Substratscheiben die gewünschten vier übereinanderliegenden Epitaxieschichten. Die Substratscheiben werden dann aus der erfindungsgemäßen Vorrichtung herausgenommen.

Die Fig. 1, 2 und 3 zeigen die erfindungsgemäße Vorrichtung in einer solchen Stellung, daß bezüglich der Schwerkraft die Schmelztiegel 5 oberhalb der Abscheidekammern 3 sind und die Substratscheiben sich in den Ausnehmungen. 12 in senkrechter Stellung in den Abscheidekammern 3 befinden. Es ist dies die im allgemeinen vorteilhafteste Betriebslage der erfindungsgemäßen Vorrichtung 1. Für den Betrieb wird diese Vorrichtung 1, wie in Fig. 3 angedeutet, in einem Quarzrohr 100 angeordnet, das sich in einem entsprechenden Ofen befindet. Mit 101 ist ein Zuführungsrohr für Wasserstoff und mit 102 ist ein Rohr für ein Thermoelement bezeichnet.

Insbesondere bei nur einseitiger Lage von Ausnehmungen 12 in den Schieberzungen 8 kann die erfindungsgemäße Anordnung auch in einer solchen Lage benutzt werden, bei der die Schieberzungen 8 waagerecht liegen und die Ausnehmungen sich in den jeweils obenliegenden Oberflächen der Schieberzungen 8 befinden.

**Patentansprüche**

1. Vorrichtung zur Flüssigphasen-Epitaxie, mit zwei aneinanderliegenden, gegeneinander verschiebbaren Teilen, die jeweils eine gleiche Anzahl von Ausnehmungen, die als Schmelztiegel bzw. Abscheidekammern—wobei jeweils ein Schmelztiegel über je eine Abscheidekammer zu schieben ist—dienen, aufweisen und deren jeweilige Anzahl gleich ist der Anzahl der abzuscheidenden Schichten, wobei die Abstände zwischen den Abscheidekammern und die Abstände zwischen den Schmelztiegeln untereinander gleich groß und gleich oder größer als die Länge der einzelnen Schmelztiegel und/oder der Abscheidekammern—in Schubrichtung gemessen—sind, sowie mit wenigstens einer Schieberzunge mit Aufnahme für einer Substratscheibe, wobei Abscheidekammer und Schmelztiegel jeweils—in der Schubrichtung entsprechend der Längserstreckung der Schieberzunge gesehen—hintereinander angeordnet sind, gekennzeichnet dadurch,

— daß wenigstens eine in miteinander fluchtenden Schlitzen (15) geführte Schieberzunge (8) mit auf beiden Seiten gegenüberliegenden Aufnahmen (12) für je eine Substratscheibe (14) vorgesehen ist und/oder
— daß mehrere in miteinander fluchtenden Schlitzen (15) geführte Schieberzungen (8, 8′) mit wenigstens je einer Aufnahme (12) für je eine Substratscheibe (14) vorgesehen sind und
— daß die Schlitze (15) mit der Höhe (A) senkrecht bezogen auf die Auflagefläche (6) der Teile (2, 4) mit den Schmelztiegeln (5) bzw. den Abscheidekammern (3) durch die Wände der Abscheidekammern geführt sind.

2. Vorrichtung nach Anspruch 1, gekennzeichnet dadurch, daß die Abmessungen (a, b) der Aufnahmen (12) passend zu den vorgesehen Substratscheiben (14) bemessen sind und soweit etwas größer als die korrespondierenden Abmessungen (a′, b′) der Abscheidekammern (3) sind, so daß sich wenigstens jeweils zwei Kanten der einzelnen Ausnehmung der jeweiligen Aufnahme (12) und damit jeweils zwei Kanten der einzelnen Substratscheibe beim Durchschieben der Schieberzungen (8, 8′) durch die Abscheidekammern (3) außerhalb des Querschnitts dieser Abscheidekammern (3) befinden.

3. Vorrichtung nach Anspruch 2, gekennzeichnet dadurch, daß die senkrechte Richtung parallel zur Richtung der Schwerkraft ist.

4. Vorrichtung nach Anspruch 1, 2 oder 3, gekennzeichnet dadurch, daß eine Anzahl der vorgesehenen Schieberzungen (8) auf jeweils beiden Seiten eine Aufnahme für Substratscheiben (14) haben.

5. Vorrichtung nach einem der Ansprüche 1 bis 4, gekennzeichnet dadurch, daß die beiden in den Abscheidekammern außenliegenden, in den Schlitzen (15) geführten Schieberzungen (8′) ihre jeweilige Aufnahme für die Substratscheiben (14) nur auf der—bezogen auf die Abscheidekammer (3)—nach inner gewandten Seite der jeweiligen Schieberzunge (8′) haben.

6. Vorrichtung nach einem der Ansprüche 1 bis 5, gekennzeichnet dadurch, daß das Teil (2) mit den Abscheidekammern (3) aus einzelnen zu einem Paket zusammengesetzten Platten (22) besteht, von denen zumindest die im Paket innenliegenden Platten (22) solche Aussparungen (33′, 33″) besitzen, die zusammengenommen die jeweiligen Abscheidekammern (3) bilden.

7. Vorrichtung nach Anspruch 6, gekennzeichnet dadurch, daß die Platten (22) abwechselnd zusammen mit Schieberzungen (8, 8′) in dem Paket geschichtet sind und diese Paket in ein zusammmefassendes Gehäuse (10) eingesetzt ist, wobei die jeweilige Oberkante dieser Platten (22) und die der Schieberzungen (8, 8′) gemeinsam die Auflagefläche (6) zwischen dem Teil (2) mit den Abscheidekammern (3) und dem Teil (4) mit den Schmelztiegeln (5) bilden.

8. Vorrichtung nach einem der Ansprüche 1 bis 7, gekennzeichnet dadurch, daß eine Einrichtung (41, 42, 32, 132) zum Auspressen der einzelnen Ausgangsschmelze (51) aus den einzelnen Schmelztiegeln (5) in die Abscheidekammern (3) vorgesehen ist.

9. Vorrichtung nach Anspruch 8, gekennzeichnet dadurch, daß diese Einrichtung (41, 42, 32, 132) zu Auspressen dadurch gebildet ist, daß das Teil (4) mit den Schmelzkammern (5) aus zwei Teilen (41, 42) besteht, die kammartig und mit Lücke ineinandergreifen, wobei diese Lücken die Volumina der Schmelztiegel (5) bilden, wobei durch Verschieben (9) der beiden kammartigen Teile (41, 42) gegeneinander die Größe dieser einzelnen Volumina verringert werden kann.

10. Vorrichtung nach Anspruch 9, gekennzeichnet dadurch, daß zur Verschiebung der beiden kammartigen Teile (41, 42) gegeneinander eine Anschlagnase (32) an dem Teil (2, 22) mit den Abscheidekammern (3) vorgesehen ist, so daß mit Verschiebung (9) des Teils (2, 22) mit den Abscheidekammern (3) gegenüber dem Teil (4) mit den Schmelztiegeln (5) bei Anlage dieser Anschlagnase (32) das eine kammartige Teil (41, 42) gegenüber dem anderen kammartigen Teil (42, 41) mit Verringerung des Schmelztiegelvolumens mit verschoben wird.

11. Vorrichtung nach einen der Ansprüche 8 bis 10, gekennzeichnet dadurch, daß zur gemeinsamen Verschiebung der Schieberzungen (8, 8′) und des Teils (2) mit den Abscheidekammern (3) eine lösbare Verbindung (123) zwischen den Schieberzungen (8, 8′) und diesem Teil (2) vorgesehen ist, die sich bei weiterem Verschieben der Schieberzungen (8, 8') gegenüber dem Teil (2) mit den Abscheidekammern (3) löst.

12. Vorrichtung nach Anspruch 11, gekennzeichnet dadurch, daß diese Verbindung ein Stift (123) in jeweils einer Ausnehmung (122) der Schieberzungen (8, 8') und des Teils (2) mit den Abscheidekammern (3) ist, der zum Lösen der Verbindung aus dieser Ausnehmung (123) heraustritt.

13. Vorrichtung nach einem der Ansprüche 1 bis 12, gekennzeichnet dadurch, daß zur Verwendung eines Vorsubstrats jeweils eine weitere Ausnehmung (14) für eine Vorsubstratscheibe in der jeweiligen Schieberzunge (8, 8') vorgesehen ist.

**Revendications**

1. Dispositif pour l'épitaxie en phase liquide, comprenant deux parties disposées l'une contre l'autre, pouvant couliser l'une par rapport à l'autre, qui présentent chacune un même nombre d'évidements qui servent respectivement de creusets de fusion et de chambres de dépôt— chaque creuset de fusion devant passer au-dessus d'une chambre de dépôt- ce nombre étant égal au nombre de couches à déposer, les intervalles entre les chambres de dépôt et les intervalles entre les creusets de fusion étant égaux entre eux et égaux ou supérieurs à la longueur des creusets de fusion et/ou des chambres de dépôt individuelles -mesurées suivant la direction de coulissement, les chambres de dépôt et les creusets de fusion étant disposés les uns derrière les autres dans la direction longitudinale des languettes coulissantes correspondant à la direction de coulissement, caractérisé en ce que:

— il est prévu au moins une languette coulissante (8) guidée dans des fentes (15) alignées les unes sur les autres et ayant des logements (12) opposés des deux côtés pour une plaquette de substrat (14) et/ou
— il est prévu plusieurs languettes coulissantes (8, 8') guidées dans des fentes (15) alignées les unes sur les autres et ayant chacune au moins un logement (12) pour une plaquette de substrat (14) et
— les fentes (15) hauteur (A), décomptée perpendiculairement à la surface de contact (6) des parties (2, 4) ayant les creusets de fusion (5) et les chambres de dépôt (3), traversent les parois des chambres de dépôt.

2. Dispositif suivant la revendication 1, caractérisé en ce que les dimensions (a, b) des logements (12) sont adaptées aux plaquettes de substrat (14) prévues et sont un peu plus grandes que les dimensions (a', b') correspondantes des chambres de dépôt (3) dans une mesure telle qu'au moins deux bords de l'évidement individuel de chaque logement (2) et ainsi deux bords de la plaquette de substrat individuelle se trouvent en dehors de la section transversale de ces chambres de dépôt (3) quand les languettes coulissantes (8, 8') traversent les chambres de dépôt (3).

3. Dispositif suivant la revendication 2, caractérisé en ce que la direction perpendiculaire est parallèle à la direction de la force de gravité.

4. Dispositif suivant la revendication 1, 2 ou 3, caractérisé en ce qu'un certain nombre des languettes coulissantes (8) qui sont prévues ont un logement pour des plaquettes de substrat (14) des deux côtés.

5. Dispositif suivant l'une des revendications 1 à 4, caractérisé en ce que les deux languettes coulissantes (8'), se trouvant à l'extérieur des chambres de dépôt et guidées dans les fentes (15), n'ont leurs logements pour les plaquettes de substrat (14) que sur le côté des languettes coulissantes (8') tourné vers l'intérieur par rapport aux chambres de dépôt (3).

6. Dispositif suivant l'une des revendications 1 à 5, caractérisé en ce que la partie (2) ayant les chambres de dépôt (3) est constituée de plaques (22) individuelles rassemblées en un paquet, dont au moins les plaques (22) se trouvant à l'intérieur du paquet ont des évidements (33', 33'') tels que, pris ensemble, ils forment les chambres de dépôt (3).

7. Dispositif suivant la revendication 6, caractérisé en ce que les plaques (22) sont disposées en couche alternativement ensemble avec les languettes coulissantes (8, 8') du paquet, et ce paquet est introduit dans une enveloppe (10), les bords supérieurs de ces plaques (22) et ceux des languettes coulissantes (8, 8') formant en commun la surface de contact (6) entre la partie (2) ayant les chambres de dépôt (3) et la partie (4) ayant les creusets de fusion (5).

8. Dispositif suivant l'une des revendications 1 à 7, caractérisé en ce qu'il est prévu un dispositif (41, 42, 32, 132) pour expulser des masses fondues (51) initiales individuelles, des creusets de fusion (5) individuels dans les chambres de dépôt (3).

9. Dispositif suivant la revendication 8, caractérisé en ce que ce dispositif (41, 42, 32, 132) d'expulsion est constitué par le fait que la partie (4) ayant les creusets de fusion (5) est formé de deux parties (41, 42) qui s'interpénètrent à la manière de peignes et avec des intervalles, ces intervalles formant les volumes des creusets de fusion (5), la dimension de ces volumes individuels pouvant être diminuée en faisant coulisser (9) les deux parties (41, 42) en forme de peigne l'une envers l'autre.

10. Dispositif suivant la revendication 9, caractérisé en ce que, pour faire coulisser les deux parties (41, 42) en forme de peigne l'une par rapport à l'autre, il est prévu un bec de butée (32) sur la partie (2, 22) ayant les chambres de dépôt (3), de sorte que, par le coulissement (9) de la partie (2, 22) comportant les chambres de dépôt (3) par rapport à la partie (4) comportant les creusets de fusion (5) lorsque ce bec de butée (32) vient en appui, l'une des parties (41, 42) en forme de peigne coulisse par rapport à l'autre partie (42, 41) en forme de peigne, avec diminution du volume des creusets individuels.

11. Dispositif suivant l'une des revendications 8 à 10, carctérisé en ce que, pour faire coulisser en commun des languettes coulissantes (8, 8') et la partie (2) comportant les chambres de dépôt (3), il est prévu une liaison (123) amovible entre les lanquettes coulissantes (8, 8') et cette partie (2), cette liaison se défaisant lorsque les languettes coulissantes (8, 8') continuent à coulisser par rapport à la partie (2) ayant les chambres de dépôt (3).

12. Dispositif suivant la revendication 11, caractérisé en ce que cette liaison est une tige (123) engagée dans un évidement (122) des languettes coulissantes (8, 8') et de la partie (2) ayant les chambres de dépôt (3) et qui sort de cet évidement (122) pour défaire la liaison.

13. Dispositif suivant l'une des revendications 1 à 12, caractérisé en ce que, pour l'utilisation d'un pré-substrat, il est prévu un autre évidement (14) pour une plaquette de pré-substrat dans les languettes coulissantes (8, 8').

## Claims

1. Apparatus for use in liquid-phase epitaxy, comprising two adjacent parts which are mutually displaceable and which respectively have an identical number of recesses which serve as melting crucibles or as deposition chambers, as the case may be (where each melting crucible is to be slid across a respective deposition chamber) and the number of which in each case corresponds to the number of layers which are to be separated, wherein the distances between the deposition chambers and the distances between the melting crucibles have the same value and are the same as, or larger than, the length of the individual melting crucibles and/or of the deposition chambers (measured in the direction of sliding), and comprising at least one slide blade with a receptacle for a substrate disc, wherein deposition chambers and melting crucibles are respectively arranged behind one another, considered in the direction of sliding corresponding to the longitudinal extent of the slide blade, characterised in

— that at least one slide blade (8) is provided which is guided in slots (15), which are in alignment with one another, and which slide blade is provided on both sides thereof with oppositely arranged receptacles (12) for substrate discs (14), and/or
— that a plurality of sliding blades (8, 8') are provided which are guided in slots (15) which are in alignment with one another, and which blades have at least one receptacle (12) for a substrate disc (14), and
— that the slots (15) have a height (A) and pass through the walls of the deposition chambers at right angles to the contact surface (6) of the parts (2, 4) with the melting crucibles (5), or deposition chambers (3), as the case may be.

2. Apparatus as claimed in Claim 1, characterised in that the dimensions (a, b) of the receptacles (12) are such as to match the substrate discs (14) provided and are somewhat larger than the corresponding dimensions (a', b') of the deposition chambers (3), so that at least two edges of an individual recess of a respective receptacle (12), and thus two edges of an individual substrate disc, are respectively outside the cross-section of the deposition chambers (3) when the slide blades (8, 8') are shifted across the separating chambers (3).

3. Apparatus as claimed in Claim 2, characterised in that the direction at right angles is parallel to the direction of gravity.

4. Apparatus as claimed in Claim 1, 2 or 3, characterised in that a number of the slide blades (8) provided, have a receptacle for substrate discs (14) on both sides.

5. Apparatus as claimed in one of Claims 1 to 4, characterised in that the two slide plates (8'), which are guided in the slots (15) and lie at the outside in the deposition chambers, have their respective receptacles for the substrate discs (14) only on the side of the blade facing inwardly in relation to the deposition chambers (3).

6. Apparatus as claimed in one of Claims 1 to 5, characterised in that the part (2) having the deposition chambers (3) consists of individual plates (22) which are assembled to form a packet and of which at least the plates (22), which lie within the packet have recesses (33', 33'') which together form the respective deposition chambers (3).

7. Apparatus as claimed in Claim 6, characterised in that the plates (22) are alternately layered in the packet with slide blades (8, 8') and this packet is inserted into a collecting housing (10), wherein the respective upper edges of the plates (22) and of the slide blades (8, 8') commonly form the contact surface (6) between the part (2) having the deposition chambers (3) and the part (4) having the melting crucibles (5).

8. Apparatus as claimed in one of Claims 1 to 7, characterised in that a device (41, 42, 32, 132) is provided for expressing the individual output melts (51) from the individual melting crucibles (5) into the deposition chambers (3).

9. Apparatus as claimed in Claim 8, characterised in that the expressiong device (41, 42, 32, 132) is formed in that the part (4) having the melting chambers (5) consists of two parts (41, 42) which engage in a comb-like fashion with gaps, these gaps forming the interior spaces of the melting crucibles (5), the size of these individual spaces being capable of being reduced by mutually sliding (9) the two comb-like parts (41, 42).

10. Apparatus as claimed in Claim 9, characterised in that, in order to mutually displace the two comb-like parts (41, 42), a stop projection (32) is arranged on the part (2, 22) having the deposition chambers (3), so that, on contact of the stop projection (32) by sliding (9) the part (2, 22) having the deposition chambers (3) relative to the part (4) having the melting crucibles (5), the one comb-like part (41, 42) is also shifted relative to the other comb-like part (42, 41), so reducing the volume of the melting crucible.

11. Apparatus as claimed in one of Claims 8 to 10, characterised in that, in order to commonly shift the slide blades (8, 8') and the part (2) having the deposition chambers (3), a releasable connection (123) is arranged between the slide blades (8, 8') and the part (2), which connection is released upon further movement of the slide blades (8, 8') relative to the part (2) having the deposition chambers (3).

12. Apparatus as claimed in Claim 11, characterised in that the connection is a pin (123) in a respective recess (122) of the slide blade (8, 8') and of the part (2) having the deposition chambers (3) which emerges from the recess (123) in order to release the connection.

13. Apparatus as claimed in one of Claims 1 to 12, characterised in that, in order to use a preliminary substrate, a further recess (14) is provided for a preliminary substrate disc in the respective slide blade (8, 8').

FIG 1

FIG 2

FIG 3

## FIG 4

## FIG 5

## FIG 6a

## FIG 6b

## FIG 6c